## Europäisches Patentamt
## European Patent Office
## Office européen des brevets

(19)

(11) Numéro de publication : **0 044 755**
**B1**

(12)

# FASCICULE DE BREVET EUROPÉEN

(45) Date de publication du fascicule du brevet :
**13.06.84**

(21) Numéro de dépôt : **81400904.9**

(22) Date de dépôt : **05.06.81**

(51) Int. Cl.³ : **H 01 L 23/04**, H 01 L 23/08, H 01 L 25/16

(54) **Boîtier d'encapsulation, résistant à de fortes pressions externes, pour circuit hybride.**

(30) Priorité : **19.06.80 FR 8013596**

(43) Date de publication de la demande :
**27.01.82 Bulletin 82/04**

(45) Mention de la délivrance du brevet :
**13.06.84 Bulletin 84/24**

(84) Etats contractants désignés :
**DE GB IT SE**

(56) Documents cités :
**DE-A- 1 764 263**
**FR-A- 2 253 282**
**US-A- 4 208 698**
**IBM TECHNICAL DISCLOSURE BULLETIN vol. 11, no. 8, janvier 1969, New York, US J.M. CAMERON et al.: "Installation of chips on printed circuit cards"**

(73) Titulaire : **THOMSON-CSF**
**173, Boulevard Haussmann**
**F-75379 Paris Cedex 08 (FR)**

(72) Inventeur : **Le Ny, Jacques**
**THOMSON-CSF SCPI 173, bld Haussmann**
**F-75360 Paris Cedex 08 (FR)**
Inventeur : **Val, Christian**
**THOMSON-CSF SCPI 173, bld Haussmann**
**F-75360 Paris Cedex 08 (FR)**

(74) Mandataire : **Wang, Pierre et al**
**THOMSON-CSF SCPI 173, Bld Haussmann**
**F-75379 Paris Cedex 08 (FR)**

## Description

La présente invention concerne un boîtier d'encapsulation plus particulièrement destiné aux circuits hybrides qui sont appelés à fonctionner sous de fortes pressions, uniformes et de type hydrostatique.

Il est connu que dans le cas de mesures à faibles niveaux, l'électronique d'amplification doit se trouver le plus près possible du capteur de façon à transmettre un signal amplifié, moins perturbé par le bruit ou par des parasites locaux. Ce qui est facilement réalisable à des pressions proches de la pression atmosphérique devient très délicat lorsque la pression du milieu dans lequel doit fonctionner le circuit est élevée et dépasse par exemple $10^7$ Pa.

En effet, les composants des circuits hybrides ne sont pas réalisés pour fonctionner normalement sous de fortes pressions, et les pastilles de circuits intégrés ou de semiconducteurs, les condensateurs et résistances rapportées sur un substrat de circuit hybride cassent au-delà de quelques bars ainsi que le substrat lui-même.

Des exemples, non limitatifs, de circuits fonctionnant sous de fortes pressions sont donnés par les circuits immergés par deux ou trois mille mètres de fond, ou par les circuits introduits à l'intérieur d'installations industrielles sous pression, de façon à mesurer des débits ou pressions par exemple.

La solution généralement adoptée consiste à enfermer le circuit électronique dans un boîtier métallique, souvent de forme ronde ou cylindrique, prévu pour résister à la pression externe. Un doigt de gant qui pénètre dans une installation industrielle en est un exemple, mais qui n'est pas applicable à un circuit immergé sous plusieurs milliers de mètres d'eau. Dans ce cas, la liaison par câble nécessite alors que le boîtier métallique soit muni de passages dits « verre/métal », c'est-à-dire de connexions métalliques scellées dans le boîtier par des perles de verre. Ce type de scellement et ses passages sont éminemment fragiles.

L'invention apporte une solution à ce double problème du fonctionnement d'un circuit hybride sous forte pression et à ses connexions électriques avec l'extérieur, en proposant un boîtier hermétique conforme à la revendication 1 et constitué par un substrat plan, mince, sur lequel le circuit hybride est réalisé sur l'une ou les deux faces, et sur lequel sont rapportés deux couvercles enveloppants de forme bombée dépourvue d'angles vifs, disposés face à face de façon à pincer le substrat.

En outre, le substrat déborde le périmètre des couvercles, ce qui permet d'y fixer des broches de connexions externes, lesquelles sont reliées électriquement au circuit hybride à l'intérieur du boîtier par des pistes métalliques de faible épaisseur, déposées sur le substrat, lesquelles pistes passent entre substrat et couvercle dans l'épaisseur du joint de fermeture. Le scellement des deux couvercles sur le substrat est assuré par tout moyen connu de l'homme de l'art : un collage par une colle du type époxy sur pièce en alumine donne d'excellents résultats.

De façon plus précise, l'invention concerne un boîtier d'encapsulation résistant à de fortes pressions externes, pour circuit hybride réalisé sur substrat (10) plan en matériau de type céramique, caractérisé :

— d'une part en ce qu'il est constitué par deux demi-coquilles identiques (13 et 14), en un matériau rigide et isolant électrique, de forme bombée dépourvue d'angles vifs et présentant une concavité interne de dimensions adaptées au circuit à protéger (15), ces demi-coquilles étant disposées symétriquement sur les deux faces du substrat du circuit hybride, créant ainsi à l'intérieur du boîtier une zone hors pression, de déformation nulle ;

— d'autre part, en ce que les liaisons électriques, entre le circuit hybride (15) et les broches de connexions extérieures (11) sont assurées par des conducteurs métalliques (12) plats et minces, déposés sur au moins une face du substrat (10), et qui traversent le boîtier d'encapsulation dans le plan du joint de scellement d'une demi-coquille sur le substrat.

L'invention sera mieux comprise par la description qui en suit laquelle s'appuie sur des figures d'exemples de réalisation qui concernent :

figure 1 un boîtier de circuit hybride selon l'art connu, en céramique, adapté pour résister à une pression externe ;

figure 2 un boîtier de circuit hybride selon l'art connu, métallique ;

figure 3 une vue dans l'espace du boîtier de circuit hybride selon l'invention, muni de ses couvercles résistant aux hautes pressions ;

figure 4 une vue en éclaté d'un circuit hybride selon l'invention avec ses deux couvercles.

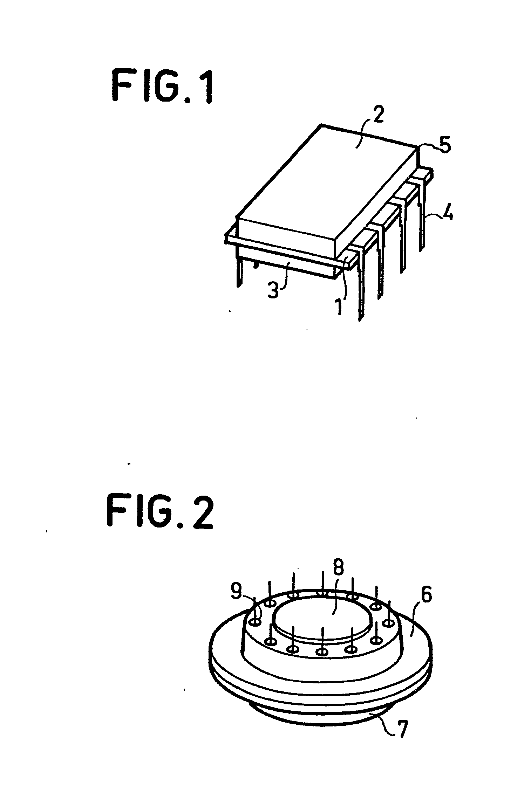

La figure 1 représente un boîtier de circuit hybride, vu dans l'espace, avec son adaptation pour résister à une pression externe.

Le circuit hybride à proprement parler est déposé sur une plaquette de substrat 1 et est protégé par un premier couvercle 2 d'un côté de la plaquette de substrat et par un second couvercle 3, de l'autre côté de la plaquette de substrat, les couvercles 2 et 3 étant en opposition. Les connexions externes sont prises par des broches d'un type connu 4. Les circuits hybrides les plus répandus sont de forme carrée ou rectangulaire, ce qui a amené tout naturellement à concevoir des couvercles 2 et 3 qui ont eux-mêmes une forme carrée ou rectangulaire adaptée au circuit hybride.

En fait, si ce type de microboîtier, ou de protection externe, convient pour de faibles pressions, il ne résiste pas lorsque les pressions s'élèvent et atteignent par exemple $10^7$ Pa, car alors il y a accumulation de contraintes dans les angles vifs 5 des couvercles qui sont disloqués et pulvérisés par la pression.

La figure 2 représente un autre boîtier de circuit hybride dans une tentative qui a été faite pour trouver une solution aux problèmes de hautes pressions.

Ce type de boîtier est inspiré des boîtiers de transistors de puissance métalliques et il est constitué par deux demi-coquilles 6 et 7 en un métal résistant tel qu'un acier inoxydable ou du titane, lesquelles demi-coquilles sont soudées sur leur périphérie. L'une des demi-coquilles, 6 sur la figure 2, correspond à l'embase d'un transistor de puissance : c'est dans sa partie centrale 8 qu'est soudé le circuit hybride, caché sur la figure puisque celui-ci se trouve à l'intérieur du boîtier. L'autre demi-coquille, 7 sur la figure 2, correspond au couvercle du boîtier du transistor de puissance. Les connexions électriques avec l'extérieur se font par l'intermédiaire de bornes de sortie qui sont isolées électriquement et scellées dans la demi-coquille 6 au moyen de perles de verre.

Il s'agit là d'une adaptation de boîtiers hybrides dans une encapsulation connue depuis longtemps, adaptation qui ne pose aucun problème pour des circuits hybrides qui doivent fonctionner à la pression atmosphérique, mais qui doivent par exemple être protégés de la corrosion par un boîtier étanche ; par contre, cette adaptation pose de délicats problèmes de résistance des passages verre/métal, ou des perles de verre 9, lorsque les pressions sont élevées, 2 à 4·10$^7$ Pa par exemple.

En outre, cette adaptation d'un boîtier connu présente industriellement l'inconvénient de nécessiter un usinage des demi-coquilles, un polissage des surfaces en contact pour la soudure et d'être réalisée dans des matériaux et au moyen de procédés coûteux, ce qui en rend, dans bien des cas, le prix prohibitif.

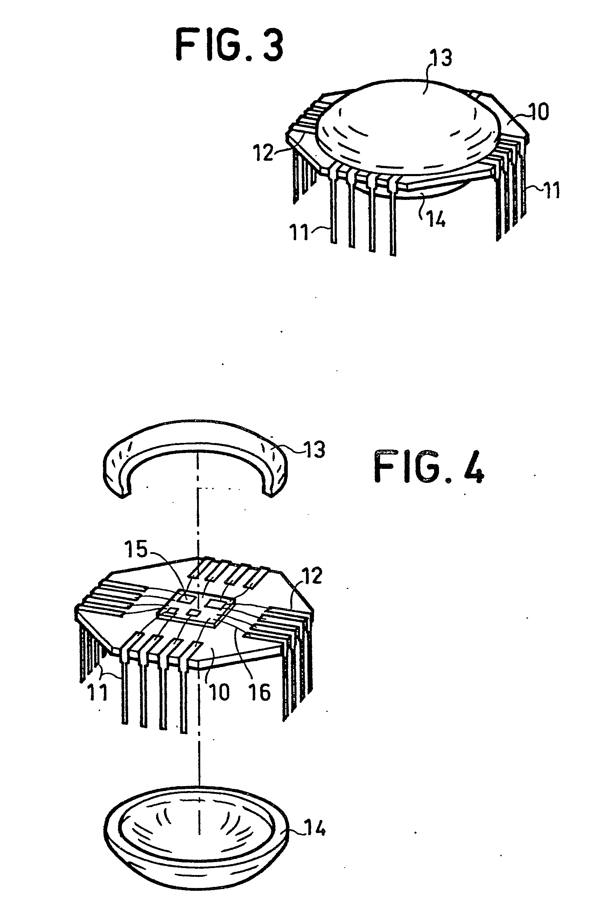

La figure 3 représente une vue dans l'espace du boîtier d'encapsulation de circuit hybride selon l'invention.

Le circuit hybride qui est destiné à fonctionner sous de fortes pressions, est réalisé sur une plaquette de substrat 10 conforme aux règles de l'art. Les plots de connexion du circuit hybride à proprement parler sont réunis aux broches de connexions externes 11 par des moyens qui seront développés ultérieurement, lesquels moyens mettent en œuvre des bandes métalliques déposées sur le substrat 10. Le boîtier d'encapsulation selon l'invention consiste, entre autre, à rapporter sur les deux faces principales du substrat 10, deux demi-coquilles ou couvercles identiques, 13 et 14, qui ont une forme bombée dépourvue d'angles vifs, ces couvercles étant fixés de part et d'autre du substrat, de telle façon que la pression exercée sur le substrat, au niveau du joint, par l'un des couvercles soit annulée par la pression exercée par l'autre couvercle, et que la partie centrale du substrat soit ainsi à l'intérieur du boîtier, hors zone de fortes pressions.

La forme circulaire de chacun des couvercles 13 et 14 est celle qui est le mieux adaptée à la résistance à la pression, puisque toute les forces sont également réparties et perpendiculaires à la paroi du couvercle. Par ailleurs, le rayon du bombement de chacun des couvercles est adapté à la pression à supporter : ce bombement peut être assez léger pour des pressions par exemple de l'ordre de 5.10$^6$ Pa et atteindre une forme demi-sphérique pour des pressions beaucoup plus élevées.

Le substrat d'un circuit hybride étant classiquement en alumine ou en un matériau céramique, les deux couvercles 13 et 14 sont également et avantageusement réalisés en alumine ou en une céramique homogène avec celle du substrat de façon à ce que les caractéristiques mécaniques et thermiques soient identiques.

L'épaisseur de chacune des deux pièces qui servent de couvercles est adaptée à la pression à supporter : elle est en tout cas suffisante sur le bord des couvercles qui entrent en contact avec le substrat 10 pour permettre un scellement, soit directement au moyen d'une colle, soit par l'intermédiaire d'un scellement par soudure, lequel nécessite alors des joints isolants pour éviter que la soudure ne court-circuite entre elles les pistes de connexion 12.

La forme ronde de chacun des couvercles appelle que le substrat soit carré. En fait, la forme carrée, qui est possible, n'est pas heureuse, car le substrat présente alors quatre triangles curvilignes qui sont fragiles, c'est pourquoi il a été trouvé qu'une forme octogonale est particulièrement avantageuse : d'une part, elle permet de fixer des broches de sortie 11 sur un à huit côtés si nécessaire, ces broches de sortie étant alignées sur chacun des côtés, ce qui correspond à l'implantation traditionnelle des broches de sortie. D'autre part, la forme octogonale permet une réalisation plus aisée des substrats qui sont découpés, soit au laser, soit par rayage, sous forme de carré, dans une plaque d'alumine, et dont les quatre coins sont ensuite redécoupés de façon à donner des octogones. Cette forme octogonale est donc industriellement plus intéressante qu'une forme carrée ou ronde délicate à réaliser et l'octogone inscrit assez bien à l'intérieur de ses côtés, la forme ronde des couvercles.

La figure 4 représente une vue en éclaté du même circuit hybride que celui de la figure 3 dans son boîtier résistant aux fortes pressions.

Cette figure permet de mieux distinguer le substrat 10 sur lequel la pastille de circuit hybride 15 est soudée selon la technologie habituelle et classique de tous les circuits hybrides aux broches de connexions extérieures 11, par l'intermédiaire des bandes métalliques plates et minces 12, au moyen de fils de connexion 16. Les bandes métalliques 12 sont représentées rectilignes, mais leur dessin peut être différent et adapté aux nécessités de la connexion du circuit hybride 15. De la même façon, on peut très bien concevoir que le circuit hybride 15 soit réuni aux broches 11 et aux bornes métalliques 12 par un système de soudure collective du style TAB, c'est-à-dire par une soudure collective au moyen d'un film pour transfert automatique sur bande.

La figure 4 a en outre l'avantage de montrer, grâce à une demi-coquille 13 qui est représentée en écorché, la forme des demi-coquilles qui servent de couvercles supérieur et inférieur pour le boîtier résistant aux fortes pressions selon l'invention.

La demi-coquille 13 met en évidence d'une part sa concavité interne, laquelle correspond au volume du circuit hybride qu'il est nécessaire de protéger contre la pression, et d'autre part, l'épaisseur du bord de cette demi-coquille. En effet, l'épaisseur de chaque demi-coquille 13 et 14 a une double fonction dans l'invention. En premier lieu, le scellement des demi-coquilles 13 et 14 sur le substrat 10 se fait par le bord des demi-coquilles et l'étanchéité est assurée grâce à un joint d'une certaine surface de colle, surface nécessaire pour que la colle puisse résister à l'effet de la pression extérieure. D'autre part, les deux demi-coquilles travaillent en opposition de force de part et d'autre du substrat et, si elles étaient trop minces, il pourrait y avoir, par exemple à la suite d'un mauvais collage de deux demi-coquilles qui ne seraient pas exactement en opposition, effet de cisaillement et cassure du substrat. En outre, si les demi-coquilles étaient minces, le ruban de colle par lequel elles adhèrent sur le substrat ne serait pas suffisant pour résister à la pression externe qui s'exerce sur le joint de colle. Toutefois, les bandes métalliques conductrices 12 étant minces, une très faible épaisseur de colle est suffisante pour assurer l'étanchéité et le collage des demi-coquilles sur le substrat et une épaisseur de quelques dizaines de microns est largement suffisante et résiste aux essais en pression.

Les bornes de connexion extérieures 11 représentées sur les figures 3 et 4 sont des broches métalliques d'un modèle connu fréquent dans les circuits hybrides. Cependant, elles sortent du domaine de l'invention à proprement parler et elles peuvent être remplacées par tout autre système convenant à l'usage demandé pour le circuit hybride tel qu'une liaison par fil directement soudé sur les bandes métalliques 12, ou par une prise par connecteur multiple.

La figure 4 ne laisse voir qu'un seul circuit hybride monté sur une face du substrat 10. Cependant, si le nombre de connexions externes le permet et si cela est nécessaire, deux circuits hybrides peuvent être montés respectivement sur chacune des faces du substrat, et les broches externes sont partagées entre celles qui sont réunies à un premier circuit hybride sur une première face du substrat, par l'intermédiaire d'un certain nombre de bandes métalliques 12 sur cette première face du substrat et celles qui sont réunies à un second circuit hybride sur la seconde face du substrat par l'intermédiaire d'autres bandes métalliques 12 situées sur l'autre face du substrat.

L'invention ne se limite pas à la description qui en a été faite en s'appuyant sur un exemple de réalisation, mais d'autres avantages et caractéristiques de l'invention ressortiront des revendications ci-après.

## Revendications

1. Boîtier d'encapsulation résistant à de fortes pressions externes, pour circuit hybride (15) réalisé sur substrat (10) plan en matériau de type céramique, caractérisé :

— d'une part en ce qu'il est constitué par deux demi-coquilles identiques (13 et 14), en un matériau rigide et isolant électrique, de forme régulièrement bombée, dépourvue d'angles vifs et présentant une concavité interne de dimensions adaptées au circuit à protéger, ces demi-coquilles (13, 14) étant disposées symétriquement sur les deux faces du substrat (10) du circuit hybride (15), ledit substrat (10) étant de dimensions plus grandes que les demi-coquilles (13, 14) formant boîtier ;

— d'autre part en ce que les liaisons électriques, entre le circuit hybride (15) et les connexions extérieures (11) sont assurées par des conducteurs métalliques (12) plats et minces, sérigraphiés sur le substrat (10), et qui traversent le boîtier d'encapsulation dans le plan du joint de scellement d'une demi-coquille sur le substrat.

2. Boîtier d'encapsulation selon la revendication 1, caractérisé en ce que les deux demi-coquilles (13 et 14) sont de forme circulaire bombée.

3. Boîtier d'encapsulation selon la revendication 1, caractérisé en ce que les deux demi-coquilles (13 et 14) sont de forme ovale bombée.

4. Boîtier d'encapsulation selon la revendication 1, caractérisé en ce que les deux demi-coquilles (13 et 14), de même diamètre, étant de dimensions plus petites que le substrat (10), celui-ci est partagé en deux zones :

— une zone intérieure au boîtier, hors pression, qui supporte le circuit hybride et la partie interne des conducteurs métalliques (12) ;

— une zone extérieure au boîtier, soumise à la pression, qui supporte sur son pourtour des broches de connexions (11) et la partie externe des conducteurs métalliques (12).

5. Boîtier d'encapsulation selon la revendication 1, caractérisé en ce que les caractéristiques mécaniques et thermiques du substrat (10) et des deux demi-coquilles (13 et 14) sont identiques, substrat et boîtier étant réalisés en un même matériau rigide et isolant électrique, tel que l'alumine.

6. Boîtier d'encapsulation selon la revendication 1, caractérisé en ce que l'épaisseur et le bombement des deux demi-coquilles (13 et 14) sont adaptés à la pression externe.

7. Boîtier d'encapsulation selon la revendication 1, caractérisé en ce que les deux demi-coquilles (13 et 14) sont assemblées sur le substrat (10) par collage au moyen d'une colle du type époxy, isolante électriquement, laquelle assure l'étanchéité au niveau des conducteurs métalliques (12).

## Claims

1. Encapsulation housing withstanding high external pressures for an hybride circuit (15) formed on a plane substrate (10) of material of ceramic type, characterized :
— on the one hand, in that it is formed of two identical half-shells (13 and 14) of a rigid and electrically insulating material and of regularly bulged shape without acute angles and having an internal concavity of dimensions adapted to the circuit to be protected, these half-shells (13, 14) being symmetrically disposed on the two faces of the substrate (10) of the hybride circuit (15), said substrate (10) having dimensions exceeding those of the half-shells (13, 14) forming the housing ;
— and on the other hand, in that the electrical connections between the hybride circuit (15) and the outer terminals (11) are ensured by thin metallic flat conductors (12) formed by serigraphy on the substrate (10) and crossing the encapsulation housing in the plane of the sealing junction of one half-shell on the substrat.

2. Encapsulation housing according to claim 1, characterized in that the two half-shells (13 and 14) have a round bulged shape.

3. Encapsulation housing according to claim 1, characterized in that the two half-shells (13 and 14) have an oval shape.

4. Encapsulation housing according to claim 1, characterized in that the two half-shells (13 and 14) have the same diameter and dimensions smaller than the substrate (10), this latter being divided into two zones :
— one zone inside the housing, but not subjected to pressure, which bears the hybrid circuit and the internal part of the metallic conductors (12) ;
— one zone outside the housing, subjected to pressure, that bears on its periphery the connections (11) and the external part of the metallic conductors (12).

5. Encapsulation housing according to claim 1, characterized in that the mechanical and thermal characteristics of the substrate (10) and of the two half-shells (13 and 14) are identical, the substrate and the housing being formed of the same rigid and electrically insulating material such as alumina.

6. Encapsulation housing according to claim 1, characterized in that the thickness and the convexity of the two half-shells (13 and 14) are adapted to the external pressure.

7. Encapsulation housing according to claim 1, characterized in that the two half-shells (13 and 14) are assembled on the substrate (10) by bonding using an adhesive of epoxy type which is electrically insulating and ensures the tightness at the metallic conductors (12).

## Ansprüche

1. Verkapselungsgehäuse, das hohen Außendrücken widersteht, für eine Hybridschaltung (15), die auf einem ebenen Substrat (10) aus Material vom Keramiktyp gebildet ist, gekennzeichnet :
— einerseits dadurch, daß es aus zwei gleichen Halbschalen (13 und 14) aus einem starren und elektrisch isolierenden Material gebildet ist, die regelmäßig gewölbt sind und keine scharfen Winkel sowie eine konkave Innenform aufweisen, deren Abmessungen an die zu schützende Schaltung angepaßt sind, wobei diese Halbschalen (13, 14) symmetrisch auf den beiden Flächen des Substrats (10) der Hybridschaltung (15) angeordnet sind und wobei das Substrat (10) größere Abmessungen als die das Gehäuse bildenden Halbschalen (13, 14) aufweist ;
— andererseits dadurch, daß die elektrischen Verbindungen zwischen der Hybridschaltung (15) und den Außenanschlüssen (11) gewährleistet sind durch flache und dünne metallische Leiter (12), die auf dem Substrat (10) durch Siebdruck aufgebracht sind und das Verkapselungsgehäuse in der Ebene der Versiegelungsverbindung einer Halbschale mit dem Substrat durchqueren.

2. Verkapselungsgehäuse nach Anspruch 1, dadurch gekennzeichnet, dass die beiden Halbschalen (13 und 14) kreisförmig gewölbt sind.

3. Verkapselungsgehäuse nach Anspruch 1, dadurch gekennzeichnet, dass die beiden Halbschalen (13 und 14) oval gewölbt sind.

4. Verkapselungsgehäuse nach Anspruch 1, dadurch gekennzeichnet, dass die beiden Halbschalen (13 und 14) mit gleichem Durchmesser, die von geringen Abmessungen als das Substrat (10) sind, welches in zwei Zonen geteilt ist :
— eine innerhalb des Gehäuses liegende, dem Druck nicht ausgesetzte Zone, welche die Hybridschaltung und den inneren Teil der metallischen Leiter (12) trägt ;
— eine ausserhalb des Gehäuses liegende, dem Druck ausgesetzte Zone, welche auf ihrem äusseren Umfang die Anschlüsse (11) und den äusseren Teil der metallischen Leiter (12) trägt.

5. Verkapselungsgehäuse nach Anspruch 1, dadurch gekennzeichnet, daß die mechanischen und thermischen Eigenschaften des Substrates (10) und der beiden Halbschalen (13 und 14) völlig gleich sind und das Substrat sowie das Gehäuse aus demselben starren und elektrisch isolierenden Material wie Aluminiumoxid gebildet sind.

6. Verkapselungsgehäuse nach Anspruch 1, dadurch gekennzeichnet, daß die Dicke und die Wölbung der beiden Halbschalen (13 und 14) an den Außendruck angepaßt sind.

7. Verkapselungsgehäuse nach Anspruch 1, dadurch gekennzeichnet, daß die beiden Halbschalen (13 und 14) auf dem Substrat (10) durch Verklebung mittels eines Klebers vom Epoxytyp zusammengesetzt sind, der elektrisch isoliert und die Abdichtung im Bereich der metallischen Leiter (12) gewährleistet.

# FIG.1

# FIG.2

# FIG. 3

# FIG. 4